# EUROPEAN PATENT APPLICATION

(11) **EP 2 887 410 A1**
(43) Date of publication of application: **24.06.2015**
(21) Application number: 14152599.8
(22) Date of filing: 27.01.2014
(51) Int. Cl.: H01L 43/08, H01L 43/10, H01F 10/32, G11C 11/16

(54) **Magnetic multilayer stack**

(30) Priority: 18.12.2013 EP 13197939
(71) Applicant: IMEC, 3001 Leuven (BE); Katholieke Universiteit Leuven, 3000 Leuven (BE)
(72) Inventor: Tahmasebi, Taiebeh, 3001 Leuven (BE); Manfrini, Mauricio, 3001 Leuven (BE); Cornelissen, Sven, 3001 Leuven (BE)
(74) Representative: Clerix, André

(57) **Abstract**

A magnetic multilayer stack for a magnetoresistance device is provided. The magnetic multilayer stack comprises a composite soft layer which, comprises a non-magnetic layer sandwiched between a first magnetic layer of CoFeBN and a second magnetic layer comprising CoFeB. The non-magnetic layer comprises Ta. A magnetoresistance device comprising the magnetic multilayer stack is also provided.

## Description

### FIELD OF THE DISCLOSURE

The present disclosure relates to a magnetic multilayer stack for a magnetoresistance device and a magnetoresistance device comprising the magnetic multilayer stack.

### BACKGROUND

Magnetic random access memory (MRAM) is emerging as an alternative to conventional semiconductor memories. Compared to static random access memory (SRAM) and dynamic random access memory (DRAM), the MRAM has an advantage of non-volatility. Compared to flash memory used for storage of information, the MRAM has the advantage of practically infinite write endurance. MRAM devices may further have the advantage of short read and write times. In order to compete with flash memory, it is desirable to increase the density of the MRAM cells in a chip, which may involve keeping the MRAM cells as small as possible. Further, in order to compete with SRAM and DRAM, it is desirable to increase the speed of operation of the MRAM cell without compromising the density. Furthermore, it is also desirable to achieve low current switching for the MRAM cell without compromising thermal stability.

Memory elements for MRAMs may include giant magnetoresistive (GMR) spin valves (SV). The GMR-SV may include two ferromagnetic layers separated by a non-magnetic metallic spacer (or barrier) layer.

However, a magnetoresistance (MR) signal larger than for GMR-SV has been found in magnetic tunnel junction (MTJ) devices where tunnelling magnetoresistance (TMR) occurs due to the use of an insulator layer as spacer layer or barrier layer between the ferromagnetic layers (i.e a soft ferromagnetic layer or free layer and a hard ferromagnetic layer or fixed layer) instead of a metallic spacer (or barrier) layer. The MTJ devices can be used in MRAM devices, where the difference in the magnetic resistance between two remanent states can be used to represent digital bits 0 and 1.

Spin-torque transfer based MRAMs (STT-MRAMs) can be scalable to very small sizes as compared to field-switchable MRAM devices. STT-MRAM devices having magnetic layers with perpendicular magnetic anisotropy (PMA) may have several advantages over STT-MRAM devices with conventional in-plane magnetized layers such as improved thermal stability, scalability and reduced spin transfer torque (STT) switching currents.

A STT-MRAM device typically comprises a magnetic tunnel junction (MTJ) element which comprises a tunneling spacer (or barrier layer) sandwiched in between a ferromagnetic hard layer (comprising a fixed magnetic layer and a pinning layer) and a ferromagnetic soft layer (or also often referred to as 'free layer'). The direction of magnetization of the hard layer is fixed, whereas the direction of magnetization of the soft layer can be changed by passing a drive current through, which drive current is polarized by the magnetization of the hard layer. When the direction of magnetization of the hard layer and the soft layer are parallel, the MTJ element is in low resistance. When the direction of magnetization of the hard layer and the soft layer are antiparallel the MTJ element is in high resistance. For a bottom pinned MTJ stack, the bottom ferromagnetic layer refers to the hard layer and the top ferromagnetic layer refers to the soft layer. For a top pinned MTJ stack, the bottom ferromagnetic layer refers to the soft layer and the top ferromagnetic layer refers to the hard layer.

For an STT-MRAM with a perpendicular geometry, materials with a high PMA such as multilayers of Co/Pd or Co/Pt or Co/Ni on the one hand and FePt or CoPt on the other hand in their chemically ordered phase (L10 phase) are considered as potential candidates. These materials are mainly preferred to be used as hard layer in the MTJ stack of MRAM devices, i.e. a magnetic layer which retains its magnetization direction during the operation of the device., Their use as the soft layer (or free layer or storage layer) in the MTJ stack is questionable. The soft layer comprises a magnetic layer/layers for which the magnetic polarization is switched during the operation of the MTJ based device.

Due to the ease in device fabrication, reasonably high anisotropy, low switching current and relatively high tunnelling magnetoresistance (TMR), a potential MTJ candidate for an STT-MRAM cell is the CoFeB-MgO based MTJ with PMA which MTJ comprises a soft layer (or free layer or storage layer) comprising CoFeB, a hard layer and a tunneling barrier (or spacer layer) of MgO sandwiched between the hard layer and the soft layer. The anisotropy of the reported material can support a device diameter of about 35 nm, limited mainly by the maximum thickness of about 1.3 nm and maximum effective anisotropy (K_{eff}.t) about 0.25 erg/cm².

There is, however, a need to improve the magnetic properties of the magnetic materials, and in particular to improve the performance of magnetoresistance devices, specifically to reduce the damping constant which leads to reducing the switching current of STT-MRAM devices..

### SUMMARY OF THE DISCLOSURE

An object of the present disclosure is to provide an improved magnetic multilayer stack for a magnetoresistance device. A further object is to provide an improved magnetoresistance device. This is achieved by providing a composite soft (or free or storage) layer in a multilayer magnetic stack with higher thickness, a reduced magnetic moment and an improved anisotropy compared to the prior art..

According to a first aspect, a magnetic multilayer stack for a magnetoresistance device is disclosed, the magnetic multilayer stack comprises a composite soft layer, the composite soft layer comprises a first magnetic layer, having a perpendicular magnetic anisotropy, comprising cobalt-iron-boron-nitride (CoFeBN) and; a second magnetic layer, having a perpendicular anisotropy, comprising cobalt-iron-boron (CoFeB) or a combination of cobalt-iron-boron (CoFeB) with cobalt (Co) or iron (Fe) and a non-magnetic layer sandwiched in between the first and the second magnetic layer, the non-magnetic layer comprising any of Ta, Ti, Hf, Cr, Cr, Ru, V, Ag,Au, W, TaN, TiN, RuO, Zr or a combination thereof.

According to embodiments of the first aspect, the magnetic multilayer stack further comprises a tunneling barrier layer at one side of the stack close to the second magnetic layer, the tunneling barrier layer comprising a non-magnetic metallic material or an insulator material.

According to embodiments of the first aspect, the magnetic multilayer stack further comprises a spacer layer at the other side of the stack close to the first magnetic layer, the spacer layer comprising a non-magnetic metallic material or an insulator material.

According to embodiments of the first aspect, the insulator material comprises an oxide selected from the group consisting of magnesium oxide, magnesium-titanium oxide, magnesium-aluminium oxide or aluminium oxide. This is advantageous as a magnetic multilayer structure is provided which may be used in a magnetic tunnel junction (MTJ). Moreover, the multilayer stack may be used in a double barrier magnetic tunnel junction (MTJ) structure which for instance allows for improved spin torque switching of the tunnelling currents in the MTJ device and improved anisotropy.

According to embodiments of the first aspect, the non-magnetic metallic material comprises any of Cu, Cr or Ru. This is advantageous as a magnetic multilayer structure is provided which may be used in a GMR device, specifically for read head sensor applications.

According to embodiments of the first aspect, the magnetic multilayer stack further comprises a hard layer close to and at the other side of the tunneling barrier layer. The tunneling barrier layer is thus sandwiched in between the hard layer and the second magnetic layer of the composite soft layer.

According to embodiments of the first aspect, the hard layer comprises a bilayer of a magnetic layer (such as Co, Fe, Ni, CoFeB or combination of thereof) with a layer of a non-magnetic material (such as Pt or Pd) or a bilayer of Co/Ni or comprises an alloy formation of FePt or CoPt, in their chemically ordered L10 phase, with perpendicular magnetic anisotropy.

According to embodiments of the first aspect, the boron concentration of the cobalt-iron-boron-nitride is in the range of 10-30 atomic percentage.

According to embodiments of the first aspect, the first magnetic layer and/or the second magnetic layer have a thickness in the range of 0.6-2 nm.

According to embodiments of the first aspect, the non-magnetic layer has a thickness in the range of 0.2-2.5 nm.

According to embodiments of the first aspect, the tunneling barrier layer has a thickness in the range of 0.8-2.5 nm.

According to embodiments of the first aspect, the spacer layer has a thickness in the range of 0.4-2.5 nm.

According to embodiments of the first aspect, the spacer layer has a smaller effective thickness than the tunneling barrier layer. The resistance-area product (RA) of the spacer layer should be lower than the resistance-area product (RA) of the tunneling barrier layer.

The spacer layer and the tunneling barrier layer may both comprise the same material, such as for example MgO.

According to embodiments of the first aspect, the first, the second magnetic layer and the non-magnetic layer may have the same thickness.

A magnetoresistive device is also disclosed comprising a magnetic multilayer stack sandwiched between a bottom electrode and a top electrode, the magnetic multilayer stack according to any of the embodiments of the first aspect.

According to a second aspect, a magnetoresistance device is disclosed, the magnetoresistance device comprises a bottom electrode, the bottom electrode comprising an upper seed layer, a first magnetic structure on the seed layer; the first magnetic structure being a soft layer or a hard layer,; a tunnel barrier structure on the first magnetic structure; the tunnel barrier layer comprising a non-magnetic metallic material or an insulator material, a second magnetic structure on the tunnel barrier structure; the second magnetic structure being a hard layer in case the first magnetic structure is the composite soft layer or the second magnetic structure being a soft layer in case the first magnetic structure is the hard layer, and a top electrode on the second magnetic structure, characterized in that: the soft layer of the first or the second magnetic structure is a composite structure comprising a first magnetic layer, having a perpendicular magnetic anisotropy comprising cobalt-iron-boron-nitride (CoFeBN) ; a second magnetic layer, having a perpendicular anisotropy, comprising cobalt-iron-boron (CoFeB) or Co or Fe or a combination thereof the second magnetic layer being located close to the tunnel barrier structure, and a non-magnetic layer sandwiched in between the first and the second magnetic layer, the non-magnetic layer comprising any of Ta, Ti, Hf, Cr, Cr, Ru, V, Ag,Au, W, TaN, TiN, RuO, Zr or a combination thereof.

According to embodiments of the second aspect, the magnetoresistance device further comprises a spacer layer close to the first magnetic layer, the spacer layer comprising a non-magnetic metallic material or an insulator material.

According to embodiments of the second aspect, the insulator material comprises an oxide selected from the group consisting of magnesium oxide, magnesium-titanium oxide, magnesium-aluminium oxide or aluminium oxide. This is advantageous as a magnetic multilayer structure is provided which may be used in a magnetic tunnel junction (MTJ). Moreover, the multilayer stack may be used in a double barrier magnetic tunnel junction (MTJ) structure which for instance allows for improved switching of the tunnelling currents in the MTJ device.

According to embodiments of the second aspect, another hard layer is provided in contact with the spacer layer. The spacer layer is thus sandwiched in between the another hard layer and the first magnetic layer. It is an advantage that a dual MTJ stack may be provided.

According to embodiments of the second aspect, the non-magnetic metallic material comprises any of Cu, Cr or Ru. This is advantageous as a magnetic multilayer structure is provided which may be used in a GMR device, specifically for read head sensor applications.

According to embodiments of the second aspect, the hard layer comprises a bilayer of magnetic layer (such as Co, Fe, Ni, CoFeB or combination of thereof) with a non-magnetic materials (such as Pt or Pd) or Co/Ni or alloy formation of FePt or CoPt with perpendicular magnetic anisotropy.

According to embodiments of the second aspect, the boron concentration of the cobalt-iron-boron-nitride is in the range of 10-30 atomic percentage.

According to embodiments of the second aspect, the first magnetic layer and/or the second magnetic layer have a thickness in the range of 0.6-2 nm.

According to embodiments of the second aspect, the non-magnetic layer has a thickness in the range of 0.2-2.5 nm.

According to embodiments of the second aspect, the tunneling barrier layer has a thickness in the range of 0.8-2.5 nm.

According to embodiments of the second aspect, the another tunneling barrier layer has a thickness in the range of 0.4-2.5 nm.

According to embodiments, the first 110, second 130 magnetic layer and the non-magnetic layer 120 may have the same thickness.

It is an advantage that the combination of the first and second magnetic layer and the non-magnetic layer according allows for a larger effective thickness of the magnetic multilayer stack and an improved PMA. Hence, an improved PMA may be obtained while mitigating problems associated with increased in-plane anisotropy as the thickness of the magnetic layer is increased.

It is an advantage that the combination of the first and second magnetic layer and the non-magnetic layer allows for a larger effective thickness of the magnetic multilayer stack such that both thermal stability and anisotropy of the multilayer stack may be improved, without sacrificing the PMA.

Further features of, and advantages with, the present disclosure will become apparent when studying the appended claims and the following description. The skilled person will realize that different features of the present disclosure may be combined to create embodiments other than those described in the following, without departing from the scope of the present disclosure.

### BRIEF DESCRIPTION OF THE DRAWINGS

The above aspects of the present disclosure will now be described in more detail, with reference to the enclosed drawings showing embodiments of the disclosure.
Figure 1 illustrates a composite soft layer according to an embodiment of the present disclosure.
Figure 2 illustrates a magnetoresistance device according to an embodiment of the present disclosure.
Figure 3 illustrates a magnetic multilayer stack according to an embodiment of the present disclosure.
Figure 4 illustrates normalized magnetic moment plotted against applied magnetic field for the magnetic multilayer stack according to embodiments of the present disclosure.
Figure 5 illustrates a magnetoresistance device according to an embodiment of the present disclosure.
Figure 6 illustrates a dual MTJ magnetoresistance device according to an embodiment of the present disclosure.

### DETAILED DESCRIPTION

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein. These embodiments are rather provided for thoroughness and completeness, and for fully conveying the scope of the disclosure to the skilled person.

The present disclosure and accompanying drawings will be described in view of top pinned Magnetic Tunnel Junction (MTJ) stack. It is clear for a person skilled in the art that the appropriate layers may be interchanged as such forming the reversed stack, i.e. a bottom pinned MTJ stack. The wording 'perpendicular magnetic anisotropy' (PMA) is to be understood as that the magnetic field is mainly oriented perpendicular to the layer, i.e. parallel to the surface normal of the layer. The PMA is induced by the surface of the layer, i.e. by interface effects of a magnetic material. It should be noted that for thicker, in other words bulk-like, layers of magnetic material in-plane anisotropy is the dominating magnetic orientation in the layer, i.e. the magnetic field is mainly oriented parallel to the layer. Accordingly, the in-plane anisotropy will normally overcome the PMA when the thickness of the magnetic layer is increased.

In order to increase the performance of magnetoresistive devices, e.g. increased density and reduced dimensions of the devices, improved magnetic multilayer stacks are needed. One way to achieve this is to increase the perpendicular magnetic anisotropy (PMA) of the multilayer stack.

According to a first aspect of the present disclosure, a magnetic multilayer stack comprising a composite soft layer is provided in order to improve the conventional type of soft layer in which a single layer of CoFeB is used. The magnetic multilayer (composite) stack comprises at least two magnetic layers separated by a non-magnetic layer. A first magnetic layer comprises cobalt-iron-boron-nitride. This first magnetic layer has a perpendicular magnetic anisotropy. A second magnetic layer is made of CoFeB or a combination of CoFeB with Co or Fe, and this second magnetic layer has a perpendicular magnetic anisotropy. The sandwiched non-magnetic layer comprises any of Ta, Ti, Hf, Cr, CrRu, V, Ag,Au, W, TaN, TiN, RuO, Zr or a combination thereof. The first 110 magnetic layer and the second 130 magnetic layer may also be referred to as analyzer layer.

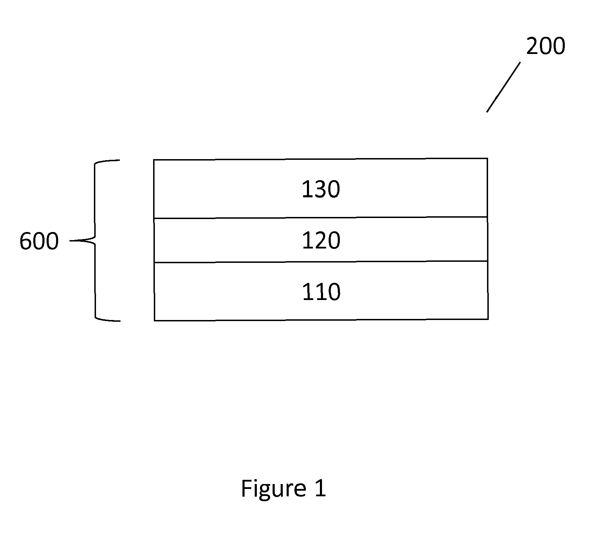

Figure 1 schematically shows such a composite soft layer 600, comprising a non-magnetic layer 120 sandwiched in between a first magnetic layer 110 and a second magnetic layer 130 according a first aspect.

The magnetic multilayer stack 600 may thus for example comprise a CoFeB/Ta/CoFeBN composite structure. By using a magnetic layer comprising CoFeBN, the PMA of the magnetic layer is improved. The non-magnetic Ta layer may absorb boron from the CoFeBN layer thereby reducing the boron composition in CoFeBN during optional annealing steps executed during fabrication of the magnetic multilayer structure. As a result, the PMA of the magnetic layer is improved. The boron concentration of the cobalt-iron-boron nitride is in the range of 10-30 atomic percentage which is advantageous in that the PMA is improved. By tuning the thicknesses of the respective layers used in the stack, the characteristics of the stack may be optimized to e.g. fit specific needs.

PMA is induced by the surface of the layer, i.e. interface effects of a magnetic material. It should be noted that for thicker (bulk-like) layers or structures of the magnetic material, in-plane anisotropy is the dominating magnetic orientation in the layer, i.e. the magnetic field is mainly oriented parallel to the layer. The magnetic layer 110 according to this embodiment has a physical thickness of 1.1 nm. This thickness ensures that the PMA is larger than the in-plane anisotropy for the magnetic layer 110.

By introducing a non-magnetic layer 120, , in between a first magnetic layer 110 comprising CoFeBN and a second magnetic layer 130 comprising CoFeB or a combination CoBeF with Co or Fe, the two magnetic layers 110, 130 may be magnetically coupled. The non-magnetic layer comprises or consists of Ta, Ti, Hf, Cr, CrRu, V, Ag, Au, W, TaN, TiN, RuO, Zr or a combination thereof. In this configuration, the first magnetic layer 110 comprising cobalt-iron-boron-nitride is preferably positioned further away from the insulating tunnel barrier layer (such as for example a MgO layer). By inserting a non-magnetic layer 120 in between the two magnetic layers 110, 130, the effective thickness of the composite structure 600 may thereby be increased while the problems associated to the in-plane anisotropy are mitigated.

The wording 'magnetically coupled' should here be understood as that the coupling strength of the magnetic layer and the additional magnetic layers in the composite structure is large enough such that the two magnetic layers 110, 130, although separated by the non-magnetic layer 120, behave as a single magnetic layer. Hence, an effectively thicker magnetic layer comprising a CoFeBN/Ta/CoFeB composite structure may be obtained which improves the thermal stability and anisotropy of the multilayer stack without sacrificing the PMA. The PMA and thermal stability of the magnetic multilayer stack (composite structure) are thus increased while the problems associated to the in-plane anisotropy are alleviated as the volume of each magnetic layer can be kept sufficiently small.

It should be noted that the effective thickness is increased when the magnetic layers 110, 130 are magnetically coupled to each other. This condition is fulfilled if the thickness of the intermediate non-magnetic layer 120 is thin enough. The thickness of the non-magnetic layer 120 is preferably in the range of 0.2-2.5 nm, as these thicknesses provides efficient magnetic coupling.. It is noted that if the non-magnetic layer 120 is too thin, it may diffuse through the magnetic layers 110, 130 after annealing and as such deteriorating the positive effect of magnetic coupling between the magnetic layers 110, 130.

According to another embodiment, the first 110 and second 130 magnetic layer may have a thickness in the range of 0.6 to 2 nm.

According to embodiments, the first 110, second 130 magnetic layer and the non-magnetic layer 120 may have the same thickness.

It should be noted that the number of layers in the stack may affect the thermal stability of the magnetic material. When the number of layers in the stack is larger, the magnetic material becomes thicker and is hence more stable.

The composition of the CoFeBN material used is commonly given as (Co₃₃Fe₆₇)_{100-x-y}BₓN_{y} (with 10<=x<=30 and 1<=y<=10). In embodiments of this disclosure, CoFeBN is formed by co-sputtering of CoₓFe_{y}B_{z}(with 10<=x,y<=70, 10<=z<=30) while nitrogen gas is flowing in the sputtering chamber. The nitrogen flow rate could vary between 1sccm to 15scum. In one embodiment, the CoₓFe_{y}B_{z} composition is Co₂₀Fe₆₆O₂₀ and nitrogen flow rate could is preferably 1sccm or 3sccm. In another embodiment of this disclosure, the CoₓFe_{y}B_{z} could be Co₆₀Fe₂₀B₂₀, while nitrogen flow rate is preferably 1sccm or 3sccm.

According embodiments, the non-magnetic layer 120 is preferably made of tantalum, Ta. This stems from the fact that the Ta layer may absorb boron from the CoFeB or CoFeBN layer to reduce the amount of boron in CoFeB or CoFeBN e.g. during the annealing steps used when fabrication the magnetic multilayer structure. As a result the PMA of the magnetic layer 110 is improved.

According to embodiments, the multilayer stack 200 may comprise a repetition of the composite structure 600. By repetition of the composite structure 600 comprising a non-magnetic layer 120 sandwiched in between a first magnetic layer 110 and second magnetic layer 130, it is possible to provide a magnetic multilayer stack 600 with a higher effective thickness in which the repeated magnetic layers 110, 130 are magnetically coupled. The effective thickness of the magnetic layers is thereby increased such that the thermal stability and the PMA of the multilayer stack are improved.

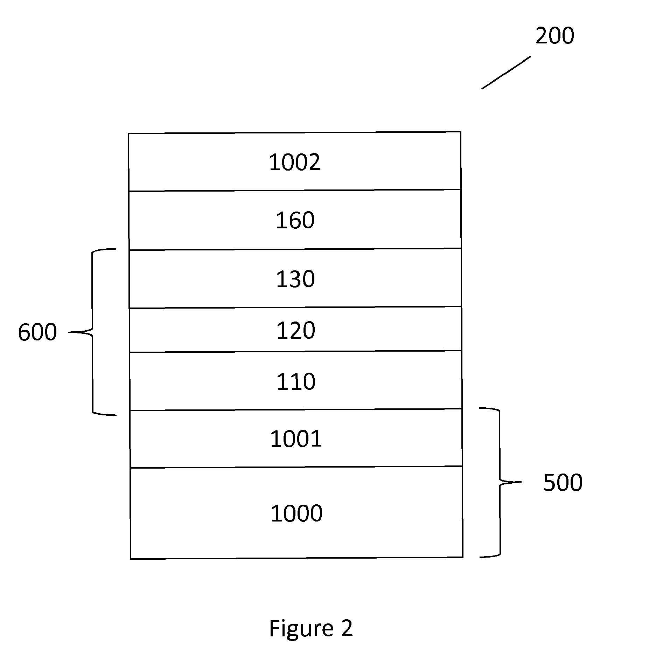

The multilayer magnetic stack 200 may further comprise a tunneling barrier layer 160 at one side close to the second magnetic layer 130, the tunneling barrier layer comprising a non-magnetic metallic material or an insulator material. Figure 2 schematically shows such a configuration thereby showing the bottom electrode 500, comprising a substrate 1000 and optional seed layer 1001, and a hard layer 1002. The composite soft layer 600 according to embodiments is thus sandwiched in between the bottom electrode 500 and the tunneling barrier layer 160. The first magnetic layer 110 comprising CoFeBN should be located further away from the tunneling barrier layer 160 than the second magnetic layer 130. For a Magnetic Tunnel Junction stack, the tunnelling barrier layer 160 comprises an oxide selected from the group consisting of magnesium oxide, magnesium-titanium oxide, magnesium-aluminium oxide or aluminium oxide. For Giant Magneto Resistor (GMR) stack the tunnelling barrier layer 160 comprises a non-magnetic metallic material chosen from Cu, Cr or Ru.

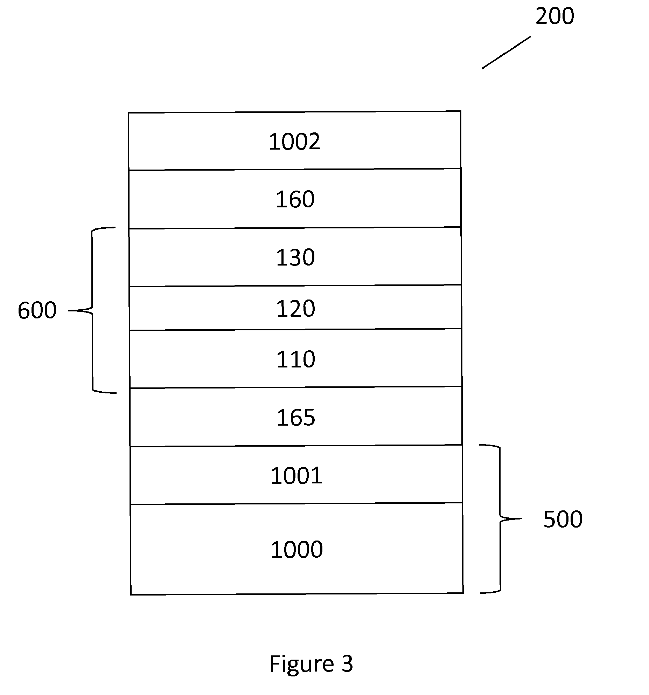

According to embodiments and as schematically shown in figure 3, the multilayer stack 200 may further comprise a spacer layer 165 at the other side of the composite structure 600 close to the first magnetic layer 110. The spacer layer 165 comprises a non-magnetic metallic material or an insulator material. The magnetic multilayer stack 200 then has a structure of a double magnetic tunnel junction (DMTJ), which for instance allows for improved switching of the tunnelling currents in a MTJ device. This spacer layer 165 preferably comprises the same material as the tunneling barrier layer 160. However the thickness of the spacer layer 165 should be much less than the thickness of the tunneling barrier layer 160. The first magnetic layer 110 is thus located closest to the spacer layer 165, otherwise said closest to the thinnest layer. One may also say that the first magnetic layer 110 should be located the closest to the MgO layer with the lowest resistance area product (RA), i.e. the smallest effective thickness. When using a tunneling barrier layer and spacer layer comprising MgO, the composite soft layer thus has two MgO interfaces.

It is advantageous to provide a composite magnetic multilayer stack 200 comprising MgO/CoFeBN/Ta/CoFeB/MgO. Such magnetic multilayer stack could be used as storage layer. This storage layer has favourable crystalline structure after post annealing, i.e. atomic lattice matching, and band alignment such that high spin polarization, high tunnelling magnetoresistance (TMR) will be achieved. Moreover, lower Gilbert damping constant was observed in CoFeBN/Ta/CoFeB/MgO stack and consequently low switching currents. An improved MTJ structure may thereby be provided. Such a MTJ stack having two MgO interfaces which show improved PMA with improved spin torque switching current, may moreover be suitable for integration with conventional transistors such as complementary metal-oxide-semiconductor (CMOS), which allows the integration of STT-MRAMs into large scale integrated circuits.

It should further be noted that in the MgO/CoFeBN/Ta/CoFeB/MgO system mainly the two MgO interfaces improve the overall interface anisotropy in such stack and thus also reduce the switching current. It is mainly the proper choice for the first magnetic layer 110, comprising CoFeBN, which reduces the Gilbert damping constant affecting the magnetic switching current.

The presence of nitrogen N in the CoFeBN material increases the interface PMA and also acts as a diffusion barrier as compared to using only CoFeB as the magnetic material in the magnetic layers 110, 130. The Ta/CoFeBN interfaces in the magnetic multilayer stack 600 also improve the PMA of the stack 200. The alternating structure of magnetic and non-magnetic layers disclosed for the magnetic multilayer stack 600 provides increased effective thicknesses of the magnetic materials used which lead to an increase in the thermal stability of the magnetic multilayer stack 600 without compromising other important parameters such as PMA and band alignment.

It should be noted that the number of layers in the stack 600 may affect the thermal stability of the magnetic material. When the number of stacks is larger, the magnetic material becomes larger and is hence more stable.

In order to provide high tunnelling probability, the tunneling barrier material 160 is in the embodiments illustrated by figures 2 and 3 and may have a thickness in the range of 0.8-2.5 nm. Preferably, the tunnel barrier layer is about 1 nm.

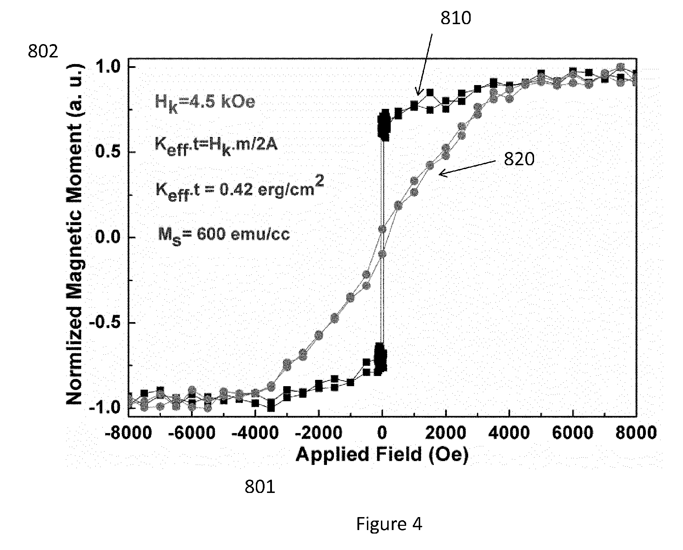

Figure 4 shows a graph of the normalized magnetic moment 802 in arbitray units (a.u.) plotted against the applied magnetic field 801 for a magnetic multilayer stack 600 comprising a CoFeBN/Ta/ CoFeB composite soft layer 600 according to embodiments of the present disclosure. It shows the magnetic hysteresis (MH). Plot 810 shows the normalized magnetic moment in case of an applied magnetic field that is oriented perpendicular to the magnetic multilayer stack, i.e. a magnetic field orientation perpendicular to the surface of the layers. Plot 820 also shows the normalized magnetic moment in the case of an applied magnetic field that is oriented in-plane of the layers of the magnetic multilayer stack 600. From the data it can be shown that this magnetic multilayer stack exhibits a strong PMA. A strong PMA can thus be achieved by using the composite soft layer structure 600 comprising a layer of CoFeBN. For this experiment, the CoFeBN magnetic layer 110 and the CoFeB magnetic layer 130, both have a thickness of 1.1 nm. A thin layer of Ta of about 1 nm is inserted as a non-magnetic layer120 in between the two magnetic layers 110,130. The magnetic-multilayer stack 600 shows a magnetic anisotropy field of about 4.5 kOe (Oersted) and an effective anisotropy Keff.t of 0.42 erg/cm². Hence, the magnetic multilayer stack 600 provides increased thermal stability. Moreover, low saturation magnetization (600 emu/cc) is obtained by the magnetic multilayer stack 400 which is important for providing reduced switching currents.

Composite free or soft layers 600, comprising a first layer, exhibiting a lower Ms anda low alpha, and a second layer, exhibiting a high Ks (interface anisotropy) and a high Tunneling Magneto Resistance (TMR) can provide for a lower switching current for the same thermal stability in perpendicular STT-MRAM applications. In this disclosure the first layer 110 comprises CoFeBN. The Nitrogen reduces Ms (saturation magnetization) and lets the magnetic damping unchanged. According to experimental results, implemented in a composite structure 600 comprising CoFeBN/Ta/CoFeB, it maintains a high TMR and adequate RA, which yields a record low alpha for 2 nm of CoFe-based free layer 600 with PMA. The damping factor reduces to 0.0085 for composite layer of CoFeBN/Ta/CoFeB composite freelayer, as compare to 0.015 for single CoFeB soft layer.

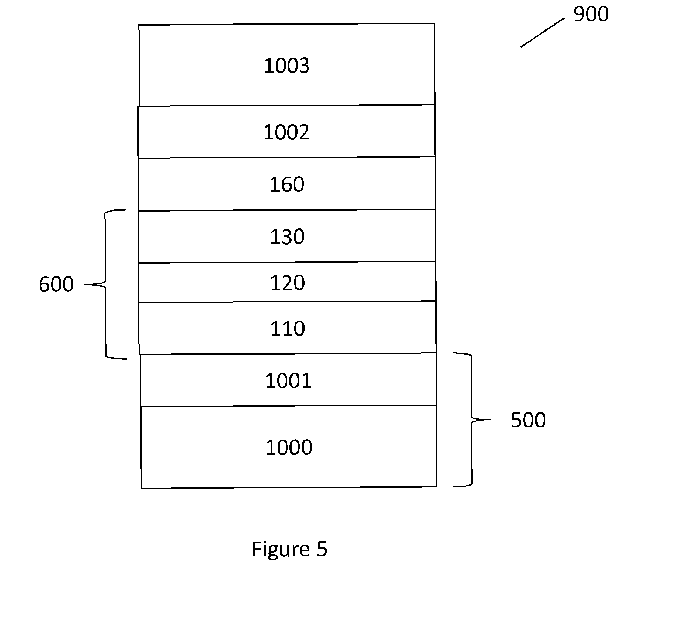

According to a second aspect of the present disclosure, a magnetoresistance device 900 is provided as illustrated by figure 5. The magnetoresistance device 900 comprises a composite soft layer 600. The magnetoresistance device comprises a bottom electrode 500, which may comprise a seed layer 1001 formed on a substrate 100,. On the bottom electrode 500 a first magnetic structure 600 is present., In case of a top pinned MTJ as shown in figure 5, the first magnetic structure 600 is a soft layer. a hard layer (not shown, i.e. In case of a bottom pinned MTJ, this first magnetic structure 600 is a hard layer. On the first magnetic structure 600, a tunnel barrier structure 160 is present, whereby the tunnel barrier layer 160 comprises a non-magnetic metallic material or an insulator material. A second magnetic structure 1002 is present on the tunnel barrier structure 160. In case of a top pinned MTJ as shown in figure 5" the second magnetic structure 1002 is a hard layer. In case of a bottom pinned MTJ, the first magnetic structure 600 is the hard layer and the second magnetic structure is a soft layer. A top electrode 1003 is present on the second magnetic structure 1002.

The soft layer in a the MTJ is a composite structure 600 comprising a first magnetic layer 110, having a perpendicular magnetic anisotropy and comprises cobalt-iron-boron-nitride (CoFeBN); a second magnetic layer 130, having a perpendicular anisotropy and comprising cobalt-iron-bron (CoFeB) or Co or Fe or a combination thereof whereby; the second magnetic layer 130 is located close to the tunnel barrier structure 160, and a non-magnetic layer 120 sandwiched in between the first magnetic layer 110 and the second magnetic layer 130., The non-magnetic layer 120 comprises any of Ta, Ti, Hf, Cr, Cr, Ru, V, Ag,Au, W, TaN, TiN, RuO, Zr or a combination thereof. This is advantageous as a magnetic multilayer stack 600 is provided which may be used in a magnetic tunnel junction (MTJ). The first magnetic layer 110 can have a thickness in the range of 0.6 nm to about 2 nm.

As said in the previous paragraph, the magnetoresistance device 900 may include a seed layer structure 1001. The seed layer 1001 includes at least one layer which may comprise a material selected from the group consisting of titan, vanadium, hafnium, chromium, magnesium oxide, chromium ruthenium, tantalum nitride, titan nitride, and ruthenium oxide. The seed layer 1001 may have a thickness ranging from about 0.1 nm to about 7 nm. The seed layer 1001 may provide a hexagonal close packing (hcp) (002) texture, a face-centered (fcc) (111) texture or a body centered (bcc) (200) texture. The seed layer 1001 may help the first magnetic layer 110 to grow in fcc (111) orientation and thus, achieving PMA in the multilayer stack. A seed layer 1001 having a smaller thickness is desirable for having a more coherent tunnelling through the tunneling barrier layer 160. PMA may be achieved in the first magnetic layer 110 with a minimum thickness of about 3 nm for the seed layer structure 1001. The magnetoresistance device 900 described provides a low switching current that can be used in spin-transfer torque magnetic random access memory (STT-MRAM). In MRAM applications, the magnetoresistance devices may be part of a memory circuit, along with transistors that provide the read and write currents. The magnetoresistance device 900 may work as or can be part of a multi-level MRAM.

Below and above the tunneling barrier layer 160 a first and a second spin-polarizing layer may be added (not shown). The first and second spin-polarizing layer preferably comprise Fe, CoFe or CoFeB or a combination thereof. They are arranged at both sides of the tunneling barrier layer 160 in order to achieve a higher magnetoresistance. The first spin-polarizing layer is then part of the composite soft layer 600, whereas the second spin-polarizing layer becomes part of the hard layer. As such the composite soft layer 600 may comprise for example a CoFeBN/Ta/Fe/CoFeB or a CoFeBN/Ta/CoFeB/Fe stack wherein the Fe layer refers to a first spin-polarizing layer. The thicknesses of the spin-polarizing layers may be varied between about 0.2 nm and about 3 nm to increase the value of the magnetoresistance. At the side of the composite soft layer 600, the spin-polarizing layer may be the same as the second magnetic layer 130.

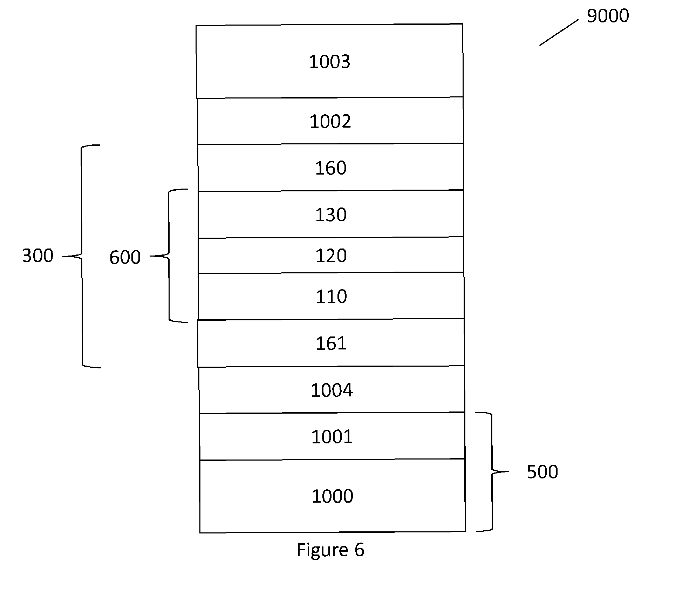

According to embodiments a dual MTJ stack may be provided, i.e. a multilayer stack comprising a composite stack comprising the composite free layer 600 according to different embodiments sandwiched in between two tunnelling barrier layers 160, 161. The composite stack with the two tunneling barrier layers 160, 161 is sandwiched in between a hard layer 1004 and another hard layer 1002. This is schematically shown in figure 6. The composite soft layer 600 comprises a non-magnetic layer 120 sandwiched in between a first magnetic layer 110 and a second magnetic layer 130. The composite soft layer 600 is sandwiched in between a first tunneling barrier layer 160 and a second tunneling barrier layer 161. This composite stack 300 is on his turn sandwiched in between a hard layer 1004 and another hard layer 1002. Below the first hard layer 1004 a bottom electrode 500 is provided in order to improve the hard layer anisotropy and above the another hard layer 1002 a top electrode 1003 is provided.

The person skilled in the art realizes that the present disclosure by no means is limited to the preferred embodiments described above. On the contrary, many modifications and variations are possible within the scope of the appended claims.

For example, the barrier layer and the spacer layer may comprise the same, or different materials, selected from the group of magnesium oxide, magnesium-titanium oxide, magnesium-aluminium oxide or aluminium oxide.

Additionally, variations to the disclosed embodiments can be understood and effected by the skilled person in practicing the claimed disclosure, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A magnetic multilayer stack (200) for a magnetoresistance device comprising
a composite soft layer (180) which comprises:
a first magnetic layer (110), having a perpendicular magnetic anisotropy, comprising cobalt-iron-boron-nitride (CoFeBN),
a second magnetic layer (130), having a perpendicular anisotropy, comprising cobalt-iron-boron (CoFeB), and;
a non-magnetic layer (120) sandwiched in between the first and the second magnetic layer, the non-magnetic layer (120) comprising any of Ta, Ti, Hf, Cr, Cr, Ru, V, Ag, Au, W, TaN, TiN, RuO, Zr or a combination thereof.

2. A magnetic multilayer stack (200) for a magnetoresistance device according to claim 1, further comprising: a tunneling barrier layer (160) at one side close to the second magnetic layer (130), the tunneling barrier layer (160) comprising a non-magnetic metallic material or an insulator material.

3. A magnetic multilayer stack (200) for a magnetoresistance device according to claim 1 or 2, further comprising: a spacer layer (165) close to the first magnetic layer (110), the spacer layer (165) comprising a non-magnetic metallic material or an insulator material.

4. A magnetic multilayer stack (200) for a magnetoresistance device according to any of claims 2 to 3, wherein the insulator material comprises an oxide selected from the group consisting of magnesium oxide, magnesium-titanium oxide, magnesium-aluminium oxide or aluminium oxide.

5. A magnetic multilayer stack (200) for a magnetoresistance device according to any of claims 2 to 3, wherein the non-magnetic metallic material comprises any of Cu, Cr or Ru.

6. A magnetic multilayer stack (200) for a magnetoresistance device according to any of claims 1 to 5 further comprising a hard layer (1002) close to and at the other side of the tunneling barrier layer (160).

7. A magnetic multilayer stack (200) for a magnetoresistance device according to any of claims 1 to 6, further comprising: another hard layer (1004), wherein the spacer layer (161) is sandwiched between the another hard layer (1004) and the first magnetic layer (110) thereby forming another tunnelling barrier layer (161).

8. A magnetic multilayer stack (200) for a magnetoresistance device according to any of claims 1 to 7 wherein the boron concentration of the cobalt-iron-boron-nitride is in the range of 10-30 atomic percentage.

9. A magnetic multilayer stack (200) according to any one of claims 1 to 8, wherein the first magnetic layer (110) and/or the second magnetic layer (130) have a thickness in the range of 0.6-2 nm.

10. A magnetic multilayer stack (200) according to any one of claims 1 to 9, wherein the non-magnetic layer (120) has a thickness in the range of 0.2-2.5 nm.

11. A magnetic multilayer stack (200) according to any one of claims 2 to 10, wherein the tunneling barrier layer (160) has a thickness in the range of 0.8-2.5 nm.

12. A magnetic multilayer stack (200) according to any one of claims 3 to 11, wherein the spacer layer (165) has a thickness in the range of 0.4-2.5 nm.

13. A magnetoresistance device (900) comprising:
- a bottom electrode (1000), the bottom electrode (1000) comprising an upper seed layer (1001);
- a first magnetic structure (600) on the seed layer (1001), the first magnetic structure being a soft layer or a hard layer;
- a tunnel barrier structure (160) on the first magnetic structure (600), the tunnel barrier layer comprising a non-magnetic metallic material or an insulator material;
- a second magnetic structure (1002) on the tunnel barrier structure (160), the second magnetic structure (1002) being a hard layer in case the first magnetic structure is the soft layer or the second magnetic structure being a soft layer in case the first magnetic structure is the hard layer;
- a top electrode (1003) on the second magnetic structure (1002);
**characterized in that**
the soft layer (600) of the first or the second magnetic structure being a composite structure comprising
- a first magnetic layer (110), having a perpendicular magnetic anisotropy, comprising cobalt-iron-boron-nitride (CoFeBN) and having a perpendicular magnetic anisotropy;
- a second magnetic layer (130), having a perpendicular anisotropy, comprising cobalt-iron-bron (CoFeB) and having a perpendicular anisotropy; the second magnetic layer being located close to the tunnel barrier structure.
- a non-magnetic layer (120) sandwiched in between the first and the second magnetic layer, the non-magnetic layer (120) comprising any of Ta, Ti, Hf, Cr, Cr, Ru, V, Ag,Au, W, TaN, TiN, RuO, Zr or a combination thereof.

14. A magnetoresistance device (900) according to claim 13 further comprising another hard layer (1004) in between the seed layer (1001) and another tunneling barrier layer (161) close to the first magnetic layer (110).
